# EUROPÄISCHE PATENTSCHRIFT

(11) **EP 2 021 811 B1**
(45) Veröffentlichungstag und Bekanntmachung des Hinweises auf die Patenterteilung: **28.12.2016**
(21) Anmeldenummer: 07724634.6
(22) Anmeldetag: 26.04.2007
(51) Int. Cl.: G01R 21/01, G01R 19/25

(54) **MESSVORRICHTUNG UND MESSVERFAHREN ZUM MESSEN DER LEISTUNG EINES HOCHFREQUENZSIGNALS**
DEVICE AND METHOD FOR MEASURING HIGH FREQUENCY SIGNAL POWER
DISPOSITIF ET PROCÉDÉ DE MESURE DE LA PUISSANCE D'UN SIGNAL HAUTE FRÉQUENCE

(30) Priorität: 26.05.2006 DE 102006024698; 14.08.2006 DE 102006038030; 04.10.2006 DE 102006046966
(43) Veröffentlichungstag der Anmeldung: 11.02.2009
(73) Patentinhaber: Rohde & Schwarz GmbH & Co. KG, 81671 München (DE)
(72) Erfinder: BRATFISCH, Toralf, 85640 Putzbrunn (DE); BENISCH, Christian, 86199 Augsburg (DE)
(74) Vertreter: Körfer, Thomas
(86) Internationale Anmeldenummer: PCT/EP2007/003704
(87) Internationale Veröffentlichungsnummer: WO 2007/137659

(56) Entgegenhaltungen:
- EP-A2- 0 405 593
- WO-A-01/36988
- GB-A- 2 067 373
- US-A- 4 968 987
- US-A- 5 493 298
- US-B1- 6 362 677

## Beschreibung

Die Erfindung betrifft eine Messvorrichtung zum Messen der Leistung, insbesondere der Hüllkurvenleistung eines Hochfrequenzsignals.

Eine Messvorrichtung nach dem Oberbegriff des Anspruchs 1 ist aus der WO 01/36988 A1 bekannt. Mit der aus dieser Druckschrift hervorgehenden Messvorrichtung kann sowohl die Hüllkurvenleistung als auch der Leistungsmittelwert bzw. Effektivwert gemessen werden. Um einen möglichst großen Dynamikbereich abzudecken, ist der Messbereich in mehrere Teilbereiche aufgeteilt, die jeweils mehreren parallel angeordneten Messzweigen zugeordnet sind. In jedem Messzweig ist jeweils ein Zerhacker (Chopper) angeordnet. Außerdem ist in jedem Messzweig ein Analog/Digital-Wandler angeordnet, der mit einer synchronen Taktrate versorgt wird. Nach gewichteter Addition der digitalisierten Messsignale der einzelnen Messzweige erfolgt eine synchrone Demodulation, bevor das Signal ausgewertet wird.

Nachteilig bei der aus der WO 01/36988 A1 bekannten Messvorrichtung ist die Verwendung paralleler Messzweige, wodurch die Messvorrichtung sehr aufwendig gestaltet ist. Neben der Synchronisierung der Chopper und der Analog/Digital-Wandler ist dafür Sorge zu tragen, dass die Gruppenlaufzeit des Messsignals in allen Messzweigen exakt gleich groß ist. Dies bereitet in der Praxis insbesondere bei zu realisierenden Video-Bandbreiten in der Größenordnung von 30 MHz Schwierigkeiten. Bei einer nur einpfadigen Realisierung der Messvorrichtung muss dafür Sorge getragen werden, dass der Analog/DigitalWandler am oberen Ende des Dynamikbereichs nicht übersteuert wird. Dies führt am unteren Ende des Dynamikbereichs zu einer nur geringen Aussteuerung. Es müssen daher besondere Maßnahmen getroffen werden, um trotzdem eine hohe Messgenauigkeit sicher zu stellen.

Aus der GB 2 067 373 A ist ein A/D-Wandler bekannt, der zur Verbesserung der Quantisierung einen Dithergenerator einsetzt.

Der Erfindung liegt die Aufgabe zugrunde, eine Messvorrichtung und ein Messverfahren zum Messen der Leistung eines Hochfrequenzsignals zu schaffen, welche bzw. welches trotz Verwendung nur eines einzigen Messzweigs eine hohe Messgenauigkeit ermöglicht.

Die Aufgabe wird bezüglich der Messvorrichtung durch die Merkmale des Anspruchs 1 und bezüglich des Messverfahrens durch die Merkmale des Anspruchs 6 gelöst. Die abhängigen Ansprüche enthalten vorteilhafte Weiterbildungen der Erfindung.

Zur Verringerung des 1/f-Rauschens und zur Verringerung des Einflusses einer thermischen Drift des Gleichspannungsverstärkers ist es vorteilhaft, vor dem Gleichspannungsverstärker einen Zerhacker (Chopper) anzuordnen, der das analoge Detektorsignal mit einem Zerhackersignal periodisch zerhackt. Die durch das Choppen verursachte Signal-Inversion kann durch einen Synchrondemodulator im Digitalsignal wieder beseitigt werden. Erfindungsgemäß wird vorgeschlagen, vor der Analog/Digital-Wandlung ein Dithersignal synchron zu dem Zerhackersignal einzuspeisen. Der Pegel des Dithersignals wird erst nach einer vollständigen Periode des Choppersignals variiert. Dies ermöglicht eine optimale Anpassung des Dithersignals an die Messaufgabe.

Die synchrone Einspeisung des Dithersignals in Bezug auf das Zerhackersignal (Choppersignal) hat den Vorteil, dass die bei einem Wechsel zwischen den Phasen des Zerhackersignals ohnehin notwendigen Wartezeiten, die zum Einschwingen des Systems nötig sind, gleichzeitig für das Einschwingen des Systems auf das neue Dithersignal genutzt werden können. Wird das Dithersignal asynchron zu dem Choppersignal gewechselt, kommen für jeden Wechsel des Dithersignals weitere Wartezeiten während des Einschwingvorgangs hinzu, die bei einem schnellabtastenden Messkopf nicht toleriert werden können.

Es ist eine Alternative der Erfindung, dass die Zeitdauer, während der das Dithersignal konstant ist, der Periodendauer des Zerhackersignals entspricht. In diesem Fall steht das gleiche Dithersignal sowohl während der positiven Phase als auch während der negativen Phase des Zerhackersignals an. Für die spätere Differenzbildung zwischen der positiven Chopper-Phase und der negativen Chopper-Phase steht dann ein Wertepaar mit gleichem Dithersignal zur Verfügung. Alternativ kann die Zeitdauer, während der das Dithersignal konstant bleibt, erfindungsgemäß auch ein anderes ganzzahliges Vielfaches der Periodendauer des Zerhackersignals sein, so dass dann mehrere Wertepaare der positiven Chopper-Periode und der negativen Chopper-Periode für die Differenzbildung zur Verfügung stehen und aus diesen Wertepaaren dann ein Mittelwert gebildet werden kann.

Wenn die Hüllkurvenleistung gemessen wird, sollte das Dithersignal und das Chopper-Signal während einer Aufnahme einer Messreihe nicht verändert werden. Typischerweise werden mehrere Messreihen hintereinander aufgenommen. Die Ditherung mit dem zu dem eigentlichen Messsignal addierten Dithersignal bewirkt dann, dass die Diskretisierungsschwellen des Analog/Digital-Wandlers relativ zu dem Messsignal sich an einer anderen Positionen befinden und bei einer Mittelung über mehrere Messaufnahmen die Diskretisierungsfehler herausgemittelt werden.

Bei dem für die Messung der Hüllkurvenleistung verwendeten Dithersignal handelt es sich um ein abschnittsweise konstantes Signal, das mit einer großen Amplitudenvariation mit gleicher relativer Häufigkeit der Einzelwerte erzeugt wird. Zur Erzeugung eines solchen Signals eignet sich ein Zähler, der kontinuierlich hochgezählte Digitalworte erzeugt. Wird erfindungsgemäß bei der Interpretation des Zählerergebnisses die Wertigkeit der Bits vertauscht, d. h. das niedrigstwertige Bit (LSB) mit dem höchstwertigen Bit (MSB) in einer Offset-Binary-Darstellung vertauscht, so entsteht eine Digitalwertfolge, die kontinuierlich ihr Vorzeichen und ihre Amplitude ändert. Durch Digital/Analog-Wandlung kann ein Analogsignal erzeugt werden, das dem Messsignal vor der Analog/DigitalWandlung zugesetzt werden kann. Die Eliminierung in dem äquivalenten Digitalsignal nach der Analog/DigitalWandlung kann in sehr einfacher Weise dadurch erfolgen, dass der Digitalwert des Dithersignals von dem Digitalwert wieder abgezogen wird bzw. mit invertiertem Vorzeichen addiert wird, nachdem es mit der Steilheit der Ditherschaltung multipliziert wurde.

Ein Ausführungsbeispiel der Erfindung wird nachfolgend unter Bezugnahme auf die Zeichnung beispielhaft näher beschrieben. In der Zeichnung zeigen:
- Fig. 1: eine Messvorrichtung nach dem Stand der Technik;
- Fig. 2: ein Ausführungsbeispiel der erfindungsgemäßen Messvorrichtung;
- Fig. 3: ein detaillierteres Blockschaltbild des Ausführungsbeispiels der erfindungsgemäßen Messvorrichtung;
- Fig. 4: eine schematische Darstellung der von dem Zähler in Fig. 3 erzeugten Digitalworte und deren Interpretation am Eingang des in Fig. 3 dargestellten Digital/Analog-Wandlers;
- Fig. 5: das Dithersignal am Ausgang des Digital/Anälog-Wandlers in Fig. 3 und
- Fig. 6: das in den Zerhacker in Fig. 3 eingespeiste Zerhackersignal.

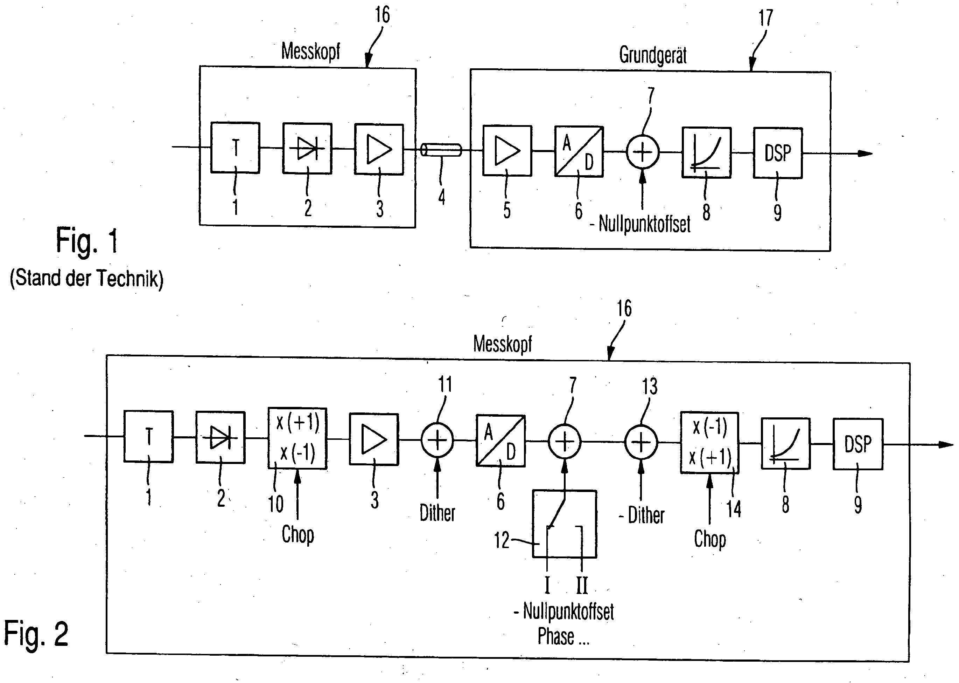

Fig. 1 zeigt eine bislang übliche Konfiguration einer Messvorrichtung zum Messen der Hüllkurvenleistung und des Leistungsmittelwerts. In einem Messkopf 16 sind ein Dämpfungsglied 1, ein Hüllkurven-Detektor 2, der als Dioden-Detektor ausgebildet sein kann, und ein Vorverstärker bzw. Leitungstreiber 3 angeordnet. Der Messkopf 16 ist über ein Verbindungskabel 4 mit dem Grundgerät 17 verbunden. In dem Grundgerät 17 befindet sich der Hauptverstärker 5, ein Analog/Digital-Wandler 6, eine Summierstufe 7 zur Subtraktion des Nullpunkt-Offsets, eine Einrichtung 8 zur Kennlinienkorrektur und ein digitaler Signalprozessor mit weiteren Auswertefunktionen, beispielsweise zur Hüllkurvenanzeige, zur Berechnung des Leistungsmittelwerts usw.. Die Einrichtung zur Kennlinienkorrektur 8 und der digitale Signalprozessor 9 bilden zusammen eine Auswerteeinrichtung 8, 9.

Fig. 2 zeigt ein Ausführungsbeispiel der erfindungsgemäßen Messvorrichtung in einem Modus A, der zur Messung der Hüllkurvenleistung dient. Ein Unterschied zu der Konfiguration nach Fig. 1 besteht darin, dass sämtliche Komponenten der erfindungsgemäßen Messvorrichtung bevorzugt im Messkopf 16 angeordnet sein können. Ein spezielles Grundgerät nur für die Leistungsmessung ist dann unter Umständen nicht mehr notwendig. Der Messkopf 17 kann beispielsweise über einen USB-Bus unmittelbar an einen PC angeschlossen werden.

Der wesentliche Unterschied besteht aber darin, dass zwischen dem Detektor 2 und dem Analog/Digital-Wandler 6 bevorzugt nach dem Verstärker 3, eine Einspeiseeinrichtung 11 zum Einspeisen eines Dithersignals Dither angeordnet ist.

Der Wert des Dithersignals Dither wird während der Aufnahme einer aus mehreren Messwerten z. B. der Hüllkurven-Leistung bestehenden Messwertereihe, die zu einer Periode des Chopper-Signals gehört, nicht verändert, sondern nur zwischen den einzelnen Messwerte-Aufnahmen variiert. Dies wird später noch veranschaulicht. Das Ditherisgnal Dither kann an einer Dither-Eliminierungseinrichtung 13 aus dem durch den Analog/Digital-Wandler 6 digitalisierten Messsignal wieder eliminiert werden. Im in Fig. 2 dargestellten Ausführungsbeispiel besteht die Dither-Eliminierungseinrichtung 14 für das Dithersignal Dither aus einem Addierer, welchem das digitale Äquivalent des ersten Dithersignals mit invertiertem Vorzeichen (-Dither) zugeführt wird, so dass das digitale Äquivalent des ersten Dithersignals von dem digitalisierten Messsignal subtrahiert wird.

Außerdem ist zwischen dem Detektor 2 und dem Gleichspannungsverstärker 3 ein Zerhacker (Chopper) 10 angeordnet. Der Chopper 10 zerhackt das Messsignal, indem zyklisch das Vorzeichen des analogen Signals invertiert wird. Das Zerhacken hat den Vorteil, das der Einfluss der thermischen Drift des Gleichspannungsverstärkers 3 erheblich reduziert wird. Des weiteren wird der Einfluss des 1/f-Rauschens reduziert. Hinter dem Analog/Digital-Wandler 6 befindet sich ein Synchrondemodulator 14, der das digitalisierte Messsignal synchron zu dem Chopper 10 mit -1 bzw. +1 multipliziert und somit den Einfluss des Choppers 10 eliminiert. Dieser Vorzeichenwechsel kann ohne echte Multiplikation nummerisch sehr einfach vollzogen werden.

Eine weitere Besonderheit bei dem in Fig. 2 dargestellten Ausführungsbeispiel besteht noch darin, dass die Einrichtung 7, 12 zur Korrektur des Nullpunktversatzes eine Umschalteinrichtung 12 aufweist, welche eine unterschiedliche Nullpunkt-Korrektur für die beiden Chop-Phasen +1 und -1 des Choppers 10 ermöglicht. Die Nullpunkt-Offsets können für die beiden Chop-Phasen in einer nicht dargestellten Speichereinrichtung unabhängig voneinander gespeichert werden. Die Umschalteinrichtung 12 wird synchron zu dem Chopper 10 betrieben.

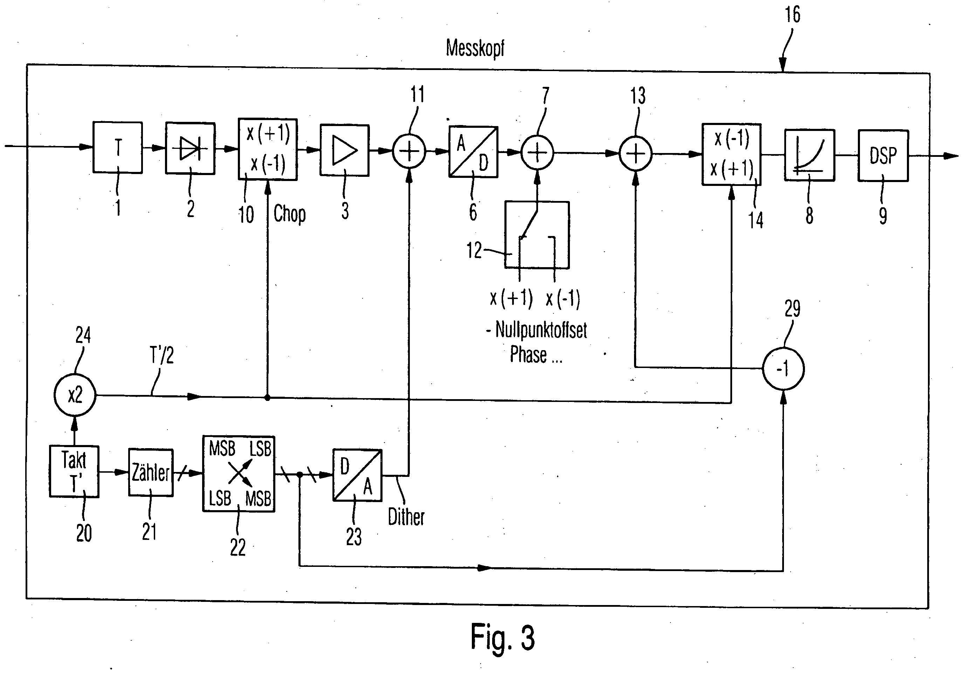

Fig. 3 zeigt ein detaillierteres Blockschaltbild, bei welchem das in Fig. 2 dargestellte Ausführungsbeispiel detaillierter dargestellt ist.

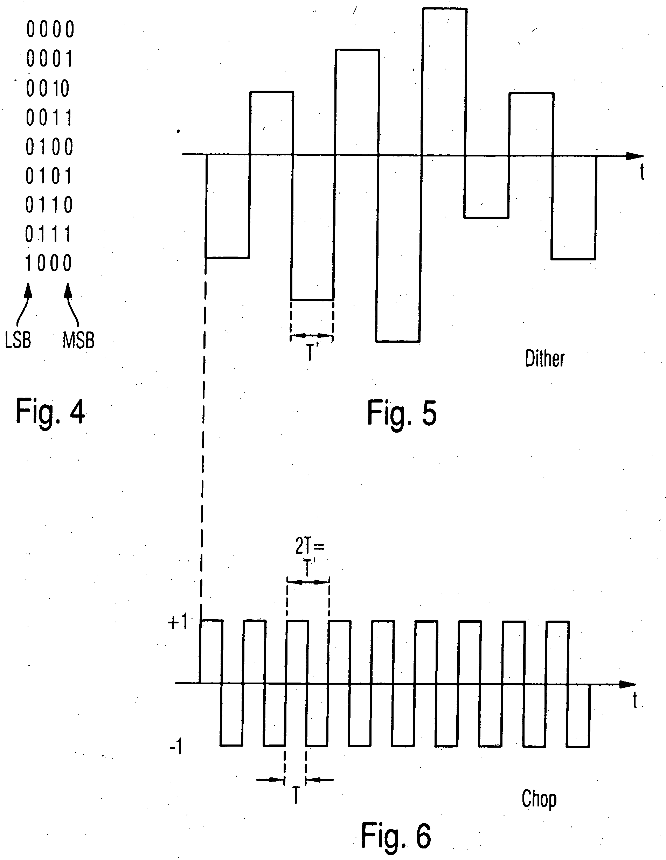

In Fig. 3 ist ein Ausführungsbeispiel zur Erzeugung des Dithersignals Dither dargestellt. Bei diesem Ausführungsbeispiel zählt ein Zähler 21 im Takt der von dem Taktgenerator 20 vorgegebenen Taktrate kontinuierlich aufwärts. Für das vereinfachte Beispiel eines 4-stelligen Zählers ist das Datenwort am Ausgang des Zählers 21 in Fig. 4 angegeben. In der Einheit 22 werden nun die Wertigkeiten der einzelnen Bits des von dem Zähler 21 erzeugten Digitalworts vertauscht, d. h. das niedrigwertige Bit LSB wird zum höchstwertigen Bit MSB, das höchstwertige Bit MSB wird zum niedrigstwertigen Bit LSB, das zweitniedrigwertige Bit wird zum zweithöchstwertigen Bit, das zweithöchstwertige Bit zum zweitniedrigwertigen Bit usw. Diese vertauschte Interpretation der Bitwertigkeit des von dem Zähler 21 erzeugten Datenworts ist in Fig. 4 mit LSB und MSB gekennzeichnet.

Interpretiert man das in seiner Bitwertigkeit vertauschte Datenwort nun in einer zweier-Komplementärdarstellung, bei welcher das höchstwertigste Bit MSB das Vorzeichen des Datenworts charakterisiert, oder einer Offset-Binary-Darstellung und gibt man diese Datenfolge auf einen Digital/Analog-Wandler 23, so entsteht ein Analog-Signal, das in Fig. 5 veranschaulicht ist. Es handelt sich dabei um ein Rechtecksignal, dessen Vorzeichen sich entsprechend der von dem Taktgenerator 20 vorgegebenen Taktrate ändert, wobei die Amplituden von Impuls zu Impuls treppenförmig ansteigt und wieder abfällt.

Das von dem Digital/Analog-Wandler 23 erzeugte Dithersignal Dither wird der Einspeiseeinrichtung 11 zugeführt und überlagert sich dort dem Messsignal. Während der Periodendauer T des in Fig. 6 dargestellten Chopper-Signals bleibt das Dithersignal Dither konstant, so dass durch das bei der Messung der Hüllkurvenleistung verwendete Dithersignal Dither die Hüllkurve des Messsignals nicht verändert wird. Nur zwischen den einzelnen Perioden des Chopper-Signals wird das Dithersignal Dither verändert, so dass es bei der nächsten Messaufnahme mit einem anderen Vorzeichen und einer anderen Amplitude vorliegt. Für jede Aufnahme ist der Dither-Wert daher etwas verändert, so dass die Diskretisierungsschwellen des Analog/Digital-Wandlers relativ zu dem Messsignal bei jeder Aufnahme etwas variiert werden. Wird beim sog. "Averaging "-Betrieb nachfolgend über sämtliche Aufnahmen gemittelt, wird dadurch nicht nur das Signal/Rausch-Verhältnis verbessert, sondern auch der Diskretisierungsfehler des Analog/Digital-Wandlers verringert. Vorraussetzung dafür ist aber, dass sich das Dithersignal Dither während der Chopper-Periode nicht ändert.

Der dem Dithersignal Dither entsprechende Digitalwert wird über einen Invertierer 27, welcher das Vorzeichen des Digitalwerts invertiert, auf den Addierer 13 gegeben und dort vom digitalisierten Messsignal abgezogen. Natürlich könnte statt eines Addierers 13 auch ein Subtrahierer verwendet werden und der Invertierer 29 weggelassen werden.

Der theoretische Einfluss des Dithersignals auf den digitalen Ausgangswert des Analog/Digital-Wandlers 6 kann mit einem einfachen mathematischen Modell berechnet und bei der digitalen Signalverarbeitung wieder subtrahiert werden.

Dieses mathematische Modell sieht folgendermaßen aus: Bei einem automatischen Kalibriervorgang wird der gesamte Wertebereich des Analog/Digital-Wandlers 23 mindestens einmal vollständig durchlaufen. Dies ist möglich durch die bekannte Periode der pseudozufälligen Wertefolge. Mit dem Analog/Digital-Wandler 6 wird ohne Eingangssignal zu jedem Wert der pseudozufälligen Wertefolge der resultierende Ausgangswert ermittelt. Mittels linearer Regression wird die Geradengleichung ermittelt, die die erhaltene Wertepaar-Folge bestmöglich beschreibt. Der Anstieg der Regressionsgeraden beschreibt die Steilheit der Ditherschaltung und wird im Messkopf 16 gespeichert. Die vertikale Verschiebung der Regressionsgeraden kann verworfen werden, da sie Teil des Nullpunktoffsets des Messkopfes 16 ist und durch die Nullpunkt-Korrektur in der Einrichtung 7 des Messkopfes 16 ohnehin auf Null gebracht wird. Um den theoretischen Einfluss des Dithersignals auf den Ausgangswert des Analog/Digital-Wandlers 6 zu ermitteln, wird einfach der Wert der pseudozufälligen Datenfolge mit der Steilheit der Dither-Einspeiseeinrichtung 11 multipliziert.

Wenn für jede einzelne Analog/Digital-Wandlung ein neuer Wert der pseudozufälligen Folge verwendet wird, muss gefordert werden, dass der Digital/Analog-Wandler 23 mit der Dither-Einspeiseeinrichtung 11, die das Hinzuaddieren des Dithersignals zum Eingangssignal des zu linearisierenden Analog/Digital-Wandlers übernimmt, schnell genug ist, sodass die Einschwingvorgänge in der Zeit zwischen den Analog/Digital-Wandlungen abklingen.

Oft lässt sich diese Forderung des Einschwingens zwischen zwei Analog/Digital-Wandlungen bei vertretbarem Aufwand bei hohen Abtastraten nicht erfüllen. Daher wird erfindungsgemäß daher bevorzugt nur nach jeder Chopperperiode bestehend aus nichtinvertierter und invertierter Chopper-Phase ein neuer pseusozufälliger Digitalwert in den Digital/Analog-Wandler 23 eingespeist. Der Einschwingvorgang stört dann nicht, weil der gesamte Signalweg ohnehin durch die Chopper-Umschaltung zwischen den Chopper-Phasen +1 und -1 einschwingen muss. Es werden also alle Ausgangswerte des Analog/Digital-Wandlers 6 in einer bestimmten nichtinvertierenden Chopper-Phase +1 sowie alle Ausgangswerte in der darauf folgenden invertierenden Chopper-Phase -1 mit der gleichen Ditherspannung gemessen, d.h. auch der störende Einfluss in beiden Chopper-Phasen +1 und -1 ist gleich.

In der Realität ist weiterhin der Digital/Analog-Wandler 23 nicht ideal. Durch Abweichungen der realen Bauelemente vom einfachen linearen mathematischen Modell wird die Subtraktion des theoretischen Einflusses des Dithersignals nicht genügen, um den Analog/Digital-Wandlerwert vollständig vom Einfluss des Ditherns zu befreien. Stattdessen wird sich ohne weitere Maßnahmen der verbliebene Einfluss das Dithersignal in einem zusätzlichen Rauschen bemerkbar machen.

Um dies zu vermeiden, wird bevorzugt den selben Abschnitt der pseudozufälligen Folge zweimal hintereinander eingespeist, und zwar erstens, wenn das nichtinvertiertierte Eingangssignal in der positiven Chopper-Phase +1 anliegt, und zweitens, wenn das invertierte Eingangssignal in der negativen Chopper-Phase -1 anliegt. Auf diese Weise ist sichergestellt, dass der störende Einfluss des Dithersignals auf den Mittelwert der gemessenen Leistung in der nichtinvertierten Chopper-Phase +1 und der invertierten Chopper-Phase -1 gleich groß ist. Durch anschließende Differenzbildung zwischen nichtinvertierter und invertierter Chopper-Phase wird der störende Einfluss des Dithers vollständig eliminiert. Die Differenzbildung zwischen nichtinvertierter und invertierter Chopper-Phase findet ohnehin im Chopperbetrieb statt, um andere störende Einflüsse des Signalweges, z. B. die Offsetspannungsdrift der Verstärker und das 1/f-Rauschen, zu eliminieren. Dies stellt also keinen Mehraufwand dar.

Durch die Synchronisierung des Dithersignals mit dem Zerhackersignals (Choppersignal) wird also erreicht, dass die bei einem Wechsel zwischen den Chopper-Phasen ohnehin notwendige Wartezeit bis zum Einschwingen des Systems gleichzeitg genutzt wird, um auch das Dithersignal zu wechseln, so dass für den Wechsel des Dithersignals keine zusätzliche Wartezeit benötigt wird.

Um die Synchronisierung zwischen dem Dithersignal Dither und dem Choppersignal Chop zu erreichen, wird der Taktgenerator 20 bevorzugt nicht nur zur Erzeugung des Dithersignals Dither, sondern auch zur Erzeugung des Choppersignals Chop verwendet. Dazu wird das Taktsignal der Periodenlänge T' des Taktgenerators 20 nicht nur in den Zähler 21, sondern auch in einen Frequenzverdoppler 24 eingespeist, so dass das Taktsignal am Ausgang des Frequenzverdopplers 24 noch eine Periodenlänge von T'/2 hat. Dieses Taktsignal ist sowohl dem Chopper 10 als auch dem Synchrondemodulator 14 zugeführt, so dass der Chopper 10 und der Synchrondemodulator 14 jeweils nach der Zeitdauer T'/2 die Chopper-Phase entweder von +1 nach **-**1 oder von -1 nach +1 wechseln. Somit wird das Dithersignal Dither über eine vollständige Periode des Choppersignals bestehend aus der positiven Chopper-Phase +1 und der negativen Chopper-Phase -1 konstant gehalten.

Die Erfindung ist nicht auf das dargestellte Ausführungsbeispiel beschränkt. Bei dem Dithersignal ist es der Fall, dass sich das Vorzeichen des Dithersignals von Takt zu Takt ändert. Auch könnte das Dithersignal über mehr als zwei Halbperioden des Zerhackersignals (Choppersignals) konstant bleiben.

## Patentansprüche

1. Messvorrichtung zum Messen der Leistung eines Hochfrequenzsignals mit
einem Detektor (2) zum Detektieren des Hochfrequenzsignals und zum Erzeugen eines analogen Detektorsignals,
einem Analog/Digital-Wandler (6) zum Erzeugen eines digitalen Signals,
einem zwischen dem Detektor (2) und dem Analog/DigitalWandler (6) angeordneten Zerhacker (10), der das analoge Detektorsignal mit einem Zerhackersignal (Chop) periodisch zerhackt, und
einer Auswerteeinrichtung (8, 9) zur Auswertung des digitalen Signals,
**dadurch gekennzeichnet,**
**dass** zwischen dem Detektor (2) und dem Analog-/Digital-Wandler (6) eine Dither-Einspeiseeinrichtung (11) zum Einspeisen eines Dithersignals (Dither) angeordnet ist, wobei die Dither-Einspeiseeinrichtung (11) das Dithersignal (Dither) synchron zum Zerhackersignal (Chop) einspeist,
**dass** es sich bei dem Dithersignal (Dither) um ein abschnittsweise konstantes Signal handelt und die Zeitdauer (T'), während der das Dithersignal (Dither A) konstant ist, der Periodendauer (2T) des Zerhackersignals (Chop) entspricht oder ein ganzzahliges Vielfaches davon ist,
**dass** das Dithersignal (Dither) über einen Digital/AnalogWandler (23) aus einer zyklischen Digitalwertefolge erzeugt ist, wobei benachbarte Digitalwerte der Digitalwertefolge im statistischen Mittel einen großen Werteunterschied haben, und
**dass** die zyklische Digitalwertefolge mittels eines Zählers (21) erzeugt ist, wobei in einer Offset-Binary-Darstellung oder Zweier-Komplementärdarstellung das höchstwertige Bit (MSB) jedes von dem Zähler (21) erzeugten Digitalwerts als niedrigstwertiges Bit (LSB) des Digital/Analog-Wandlers (23) und das niedrigstwertige Bit (LSB) jedes von dem Zähler (21) erzeugten Digitalwerts als höchstwertiges Bit (MSB) des Digital/Analog-Wandlers (23) benutzt ist.

2. Messvorrichtung nach Anspruch 1,
**dadurch gekennzeichnet,**
**dass** zwischen dem Analog/Digital-Wandler (6) und der Auswerteeinrichtung (8, 9) ein Synchrondemodulator (14) angeordnet ist, der synchron zu dem Zerhacker (10) arbeitet.

3. Messvorrichtung nach Anspruch 2,
**dadurch gekennzeichnet,**
**dass** der Synchrondemodulator (14) von dem Zerhackersignal (Chop) angesteuert ist.

4. Messvorrichtung nach einem der Ansprüche 1 bis 3,
**dadurch gekennzeichnet,**
**dass** zwischen dem Analog/Digital-Wandler (6) und der Auswerteeinrichtung (8, 9) eine Dither-Eliminationseinrichtung (13) zum Eliminieren des Dithersignals (Dither) angeordnet ist.

5. Messvorrichtung nach einem der Ansprüche 1 bis 4,
**dadurch gekennzeichnet,**
**dass** zwischen dem Analog/Digital-Wandler (6) und der Auswerteeinrichtung (8, 9) eine Einrichtung (7, 12) zur
Korrektur eines Nullpunktversatzes angeordnet ist.

6. Meßverfahren zum Messen der Leistung eines Hochfrequenzsignals mit den Verfahrensschritten Erzeugen eines analogen Detektorsignals durch Detektieren des Hochfrequenzsignals,
periodisches Zerhacken des analogen Detektorsignals mit einem Zerhackersignal (Chop),
Analog/Digital-Wandeln und Erzeugen eines digitalen Signals mittelbar oder unmittelbar aus dem zerhackten Detektorsignal und
Auswerten des digitalen Signals
**dadurch gekennzeichnet,**
**dass** vor dem Analog/Digital-Wandeln ein Dithersignal (Dither) eingespeist wird, wobei das Dithersignal (Dither) synchron zum Zerhackersignal (Chop) eingespeist wird und als Dithersignal (Dither) ein abschnittsweise konstantes Signal verwendet wird und die Zeitdauer (T'), während der das Dithersignal (Dither) konstant ist, der Periodendauer (2T) des Zerhackersignals (Chop) entspricht oder ein ganzzahliges Vielfaches davon ist,
**dass** das Dithersignal (Dither) über einen Digital/AnalogWandler (23) aus einer zyklischen Digitalwertefolge erzeugt wird, wobei benachbarte Digitalwerte der Digitalwertefolge im statistischen Mittel einen großen Werteunterschied haben, und
**dass** die zyklische Digitalwertefolge mittels eines Zählers (21) erzeugt wird, wobei in einer Offset-Binary-Darstellung oder Zweier-Komplementärdarstellung das höchstwertige Bit (MSB) jedes von dem Zähler (21) erzeugten Digitalwerts als niedrigstwertiges Bit (LSB) für die Digital/Analog-Wandlung und das niedrigstwertige Bit (LSB) jedes von dem Zähler (21) erzeugten Digitalwerts als höchstwertiges Bit (MSB) für die Digital/Analog-Wandlung benutzt wird.

7. Messverfahren nach Anspruch 6,
**dadurch gekennzeichnet,**
**dass** nach der Analog/Digital-Wandlung eine Synchrondemodulation durchgeführt wird, wobei die Sychrondemodulation synchron zu dem Zerhacken betrieben wird.

8. Messverfahren nach Anspruch 7,
**dadurch gekennzeichnet,**
**dass** der Synchrondemodulation von dem Zerhackersignal (Chop) gesteuert wird.

9. Messverfahren nach einem der Ansprüche 6 bis 8,
**dadurch gekennzeichnet,**
**dass** das Dithersignal (Dither) nach dem Analog/Digital-Wandeln wieder eliminiert wird.

10. Messverfahren nach einem der Ansprüche 6 bis 9,
**dadurch gekennzeichnet,**
**dass** nach der Analog/Digital-Wandlung eine Korrektur eines Nullpunktversatzes erfolgt.

## Claims

1. Measuring apparatus for measuring the power of a high-frequency signal, having
a detector (2) for detecting the high-frequency signal and for producing an analogue detector signal,
an analogue/digital convertor (6) for producing a digital signal,
a chopper (10), arranged between the detector (2) and the analogue/digital convertor (6), that periodically chops the analogue detector signal with a chopper signal (Chop), and
an evaluation device (8, 9) for evaluating the digital signal,
**characterized**
**in that** the detector (2) and the analogue/digital convertor (6) have a dither supply device (11) arranged between them for supplying a dither signal (Dither), wherein the dither supply device (11) supplies the dither signal (Dither) in sync with the chopper signal (Chop),
**in that** the dither signal (Dither) is a sectionally constant signal and the period of time (T') during which the dither signal (Dither A) is constant corresponds to the period duration (2T) of the chopper signal (Chop) or is an integer multiple thereof,
**in that** the dither signal (Dither) is produced by means of a digital/analogue convertor (23) from a cyclic digital value sequence, wherein adjacent digital values of the digital value sequence have a large value difference on statistical average, and
**in that** the cyclic digital value sequence is produced by means of a counter (21), wherein an offset binary representation or two's complement representation uses the most significant bit (MSB) of each digital value produced by the counter (21) as the least significant bit (LSB) of the digital/analogue convertor (23) and uses the least significant bit (LSB) of each digital value produced by the counter (21) as the most significant bit (MSB) of the digital/analogue convertor (23).

2. Measuring apparatus according to Claim 1,
**characterized**
**in that** the analogue/digital convertor (6) and the evaluation device (8, 9) have a synchronous demodulator (14) arranged between them that operates in sync with the chopper (10).

3. Measuring apparatus according to Claim 2,
**characterized**
**in that** the synchronous demodulator (14) is actuated by the chopper signal (Chop).

4. Measuring apparatus according to one of Claims 1 to 3,
**characterized**
**in that** the analogue/digital convertor (6) and the evaluation device (8, 9) have a dither elimination device (13) arranged between them for eliminating the dither signal (Dither).

5. Measuring apparatus according to one of Claims 1 to 4,
**characterized**
**in that** the analogue/digital convertor (6) and the evaluation device (8, 9) have a device (7, 12) arranged between them for correcting a zero point offset.

6. Measuring method for measuring the power of a high-frequency signal, having the method steps of production of an analogue detector signal by detecting the high-frequency signal,
periodic chopping of the analogue detector signal with a chopper signal (Chop),
analogue/digital conversion and production of a digital signal indirectly or directly from the chopped detector signal, and
evaluation of the digital signal,
**characterized**
**in that** the analogue/digital conversion is preceded by a dither signal (Dither) being supplied, wherein the dither signal (Dither) is supplied in sync with the chopper signal (Chop) and the dither signal (Dither) used is a sectionally constant signal and the period of time (T') during which the dither signal (Dither) is constant corresponds to the period duration (2T) of the chopper signal (Chop) or is an integer multiple thereof,
**in that** the dither signal (Dither) is produced by means of a digital/analogue convertor (23) from a cyclic digital value sequence, wherein adjacent digital values of the digital value sequence have a large value difference on statistical average, and
**in that** the cyclic digital value sequence is produced by means of a counter (21), wherein an offset binary representation or two's complement representation uses the most significant bit (MSB) of each digital value produced by the counter (21) as the least significant bit (LSB) for the digital/analogue conversion and uses the least significant bit (LSB) of each digital value produced by the counter (21) as the most significant bit (MSB) for the digital/analogue conversion.

7. Measuring method according to Claim 6,
**characterized**
**in that** the analogue/digital conversion is followed by a synchronous demodulation being performed, wherein the synchronous demodulation is operated in sync with the chopping.

8. Measuring method according to Claim 7,
**characterized**
**in that** the synchronous demodulation is controlled by the chopper signal (Chop).

9. Measuring method according to one of Claims 6 to 8,
**characterized**
**in that** the dither signal (Dither) is eliminated again after the analogue/digital conversion.

10. Measuring method according to one of Claims 6 to 9,
**characterized**
**in that** the analogue/digital conversion is followed by a zero point offset correction being made.

## Revendications

1. Dispositif de mesure destiné à mesurer la puissance d'un signal haute fréquence, doté
d'un détecteur (2) pour détecter le signal haute fréquence et pour produire un signal analogique de détection,
d'un convertisseur analogique/numérique (6) pour produire un signal numérique,
d'un hacheur (10) agencé entre le détecteur (2) et le convertisseur analogique/numérique (6), lequel hacheur hache périodiquement le signal de détection analogique avec un signal de hachage (Chop), et
d'un dispositif d'analyse (8, 9) pour analyser le signal numérique,
**caractérisé**
**en ce qu'**un dispositif d'injection de bruits de vibration (11) entre le détecteur (2) et le convertisseur analogique/numérique (6) est agencé pour injecter un signal de vibration (Dither), dans lequel le dispositif d'injection de bruits de vibration (11) injecte le signal de vibration (Dither) en synchronie avec le signal de hachage (Chop),
**en ce que** le signal de vibration (Dither) est un signal constant par morceaux et la durée (T') pendant laquelle le signal de vibration (Dither A) est constant correspond à la durée de la période (2T) du signal de hachage (Chop) ou en est un multiple entier,
**en ce que** le signal de vibration (Dither) est produit à partir d'une suite à valeurs numériques cyclique via un convertisseur analogique/numérique (23), dans lequel des valeurs numériques adjacentes de la suite à valeurs numériques présentent une grande différence de valeur en moyenne statistique, et
**en ce que** la suite à valeurs numériques cyclique est produite au moyen d'un compteur (21), dans lequel dans une présentation offset binaire ou présentation de complément à deux, le bit le plus significatif (most significant bit, MSB) de chaque valeur numérique produite par le compteur (21) est utilisé comme bit le moins significatif (least significant bit, LSB) du convertisseur analogique/numérique (23) et le bit le moins significatif (LSB) de chaque valeur numérique produite par le compteur (21) est utilisé comme bit le plus significatif (MSB) du convertisseur analogique/numérique (23).

2. Dispositif de mesure selon la revendication 1,
**caractérisé**
**en ce qu'**un démodulateur synchrone (14) est agencé entre le convertisseur analogique/numérique (6) et le dispositif d'analyse (8, 9), lequel démodulateur synchrone travaille en synchronie avec le hacheur (10).

3. Dispositif de mesure selon la revendication 2,
**caractérisé**
**en ce que** le démodulateur synchrone (14) est commandé par le signal de hachage (Chop).

4. Dispositif de mesure selon l'une des revendications 1 à 3,
**caractérisé**
**en ce qu'**un dispositif d'élimination de bruits de vibration (13) entre le convertisseur analogique/numérique (6) et le dispositif d'analyse (8, 9) est agencé pour éliminer le signal de vibration (Dither).

5. Dispositif de mesure selon l'une des revendications 1 à 4,
**caractérisé**
**en ce qu'**un dispositif (7, 12) est agencé entre le convertisseur analogique/numérique (6) et le dispositif d'analyse (8, 9) pour corriger un déport du point zéro.

6. Procédé de mesure destiné à mesurer la puissance d'un signal haute fréquence et comprenant les étapes consistant à
produire un signal analogique de détection par détection du signal haute fréquence,
hacher de manière périodique le signal analogique de détection avec un signal de hachage (Chop),
réaliser une conversion analogique/numérique et produire un signal numérique directement ou indirectement à partir du signal de détection haché, et
analyser le signal numérique
**caractérisé**
**en ce qu'**un signal de vibration (Dither) est injecté avant la conversion analogique/numérique, dans lequel le signal de vibration (Dither) est injecté en synchronie avec le signal de hachage (Chop) et où un signal constant par morceaux est employé comme signal de vibration (Dither) et la durée (T') pendant laquelle le signal de vibration (Dither) est constant correspond à la durée de la période (2T) du signal de hachage (Chop) ou en est un multiple entier,
**en ce que** le signal de vibration (Dither) est produit à partir d'une suite à valeurs numériques cyclique via un convertisseur analogique/numérique (23), dans lequel des valeurs numériques adjacentes de la suite à valeurs numériques présentent une grande différence de valeur en moyenne statistique, et
**en ce que** la suite à valeurs numériques cyclique est produite au moyen d'un compteur (21), dans lequel dans une présentation offset binaire ou présentation de complément à deux, le bit le plus significatif (MSB) de chaque valeur numérique produite par le compteur (21) est utilisé comme bit le moins significatif (LSB) pour la conversion analogique/numérique et le bit le moins significatif (LSB) de chaque valeur numérique produite par le compteur (21) est utilisé comme bit le plus significatif (MSB) pour la conversion analogique/numérique.

7. Procédé de mesure selon la revendication 6,
**caractérisé**
**en ce qu'**une démodulation synchrone est effectuée après la conversion analogique/numérique, dans lequel la démodulation synchrone est pratiquée en synchronie avec le hachage.

8. Procédé de mesure selon la revendication 7,
**caractérisé**
**en ce que** la démodulation synchrone est commandée par le signal de hachage (Chop).

9. Procédé de mesure selon l'une des revendications 6 à 8,
**caractérisé**
**en ce que** le signal de vibration (Dither) est de nouveau éliminé après la conversion analogique/numérique.

10. Procédé de mesure selon l'une des revendications 6 à 9,
**caractérisé**
**en ce qu'**une correction d'un déport du point zéro est effectuée après la conversion analogique/numérique.
